(19) Europäisches Patentamt
European Patent Office
Office européen des brevets

(11) **EP 2 733 125 A1**

## (12) EUROPEAN PATENT APPLICATION
published in accordance with Art. 153(4) EPC

(43) Date of publication:
**21.05.2014 Bulletin 2014/21**

(21) Application number: **12810838.8**

(22) Date of filing: **12.07.2012**

(51) Int Cl.:
**C03C 17/245** (2006.01)  **C03B 25/08** (2006.01)
**C03C 17/34** (2006.01)  **C23C 16/40** (2006.01)
**H01L 31/04** (2014.01)

(86) International application number:
**PCT/JP2012/067867**

(87) International publication number:
**WO 2013/008896 (17.01.2013 Gazette 2013/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.07.2011 JP 2011154315**

(71) Applicant: **Asahi Glass Company, Limited**
**Tokyo 100-8405 (JP)**

(72) Inventors:
• **HIROMATSU Kuniaki**
**Tokyo 100-8405 (JP)**

• **SHIRAI Masanobu**
**Tokyo**
**1008405 (JP)**

• **MIYASHITA Junichi**
**Tokyo 100-8405 (JP)**

• **YONEMICHI Tomohiro**
**Tokyo 100-8405 (JP)**

• **ENDO Takeo**
**Tokyo 100-8405 (JP)**

(74) Representative: **Müller-Boré & Partner**
**Patentanwälte PartG mbB**
**Friedenheimer Brücke 21**
**80639 München (DE)**

(54) **METHOD FOR MANUFACTURING LAYERED-FILM-BEARING GLASS SUBSTRATE**

(57)    A method for manufacturing a laminated film-coated glass substrate in which a laminated film is formed on a glass ribbon by a CVD method by means of a plurality of injectors disposed in the annealing furnace, wherein: the laminated film is formed at Tg+50°C or lower; and in each of the injectors, if a quantity of heat exchanged between the injector and the glass ribbon is expressed by Q1 (kW), a quantity of heat exchanged between a heater paired with the injector and the glass ribbon is expressed by Q2 (kW), and an output of the glass is expressed by P (tons/day), then the relational expression $|Q1|-P\times0.116\leq|Q2|\leq|Q1|$ is satisfied.

FIG. 2

EP 2 733 125 A1

**Description**

Technical Field

The present invention relates to a method for manufacturing a laminated film-coated glass substrate, in particular, a method for manufacturing a laminated film-coated glass substrate in which a laminated film is formed on a glass ribbon in an annealing furnace by an on-line CVD (chemical vapor deposition) method.

Background Art

As methods for forming a film on a glass ribbon by an on-line CVD method, for example, the methods described in patent documents 1 to 3 are known.
Patent document 1 discloses a technique in which an oxide containing silicon and oxygen is deposited by a CVD method on a glass ribbon present in a float bath. The document discloses the feature of using an unsaturated hydrocarbon compound and carbon dioxide as an oxygen source in the deposition in order to prevent the molten metal within the float bath from being oxidized by oxygen gas.
Patent document 2 discloses a process in which a silicon dioxide coating film and a tin oxide coating film are successively formed on a glass ribbon by means of a coating station (injector) disposed in a float bath and a coating station disposed in an annealing furnace.
Patent document 3 discloses a process in which a nozzle (injector) is disposed in the region between the outlet of a float bath and the inlet of an annealing furnace to deposit a film on the glass ribbon.

Prior Art Documents

Patent Documents

Patent Document 1: JP-A-1-201046

Patent Document 2: JP-A-3-33036

Patent Document 3: JP-B-4-35558

Summary of the Invention

Problems that the Invention Is To Solve

In general, a non-oxidizing atmosphere is used as the atmosphere surrounding the molten metal within the float bath in order to prevent the molten metal from being oxidized. Since the glass ribbon within the float bath is in a soft state, the glass ribbon is less apt to suffer warpage or cracking due to a temperature difference in the case where a deposition is conducted by a CVD method on the soft glass ribbon within the float bath.
Patent document 1 discloses the feature of using an unsaturated hydrocarbon compound and carbon dioxide as an oxygen gas source in order to prevent the molten metal within a float bath from being oxidized. This is because: an oxygen gas cannot be used for depositing an oxide in a non-oxidizing atmosphere and because it is therefore necessary to use a reactant gas which contains oxygen molecules. However, in the case where an oxide containing silicon and oxygen is deposited by this method, carbon (C) derived from the hydrocarbon or from the carbon dioxide comes into the oxide film. As a result, the film shows increased absorption and is a film deteriorated in transmittance as compared with carbon-free films.
Consequently, the oxide deposition by a CVD method in float baths has a problem that the film quality is deteriorated, and it is desired to conduct deposition outside the float bath.
Patent document 2 points out that in the case where a coating station is contained in an annealing furnace, the temperature conditions for deposition differ from the temperature conditions for annealing the glass ribbon, thereby posing a problem, and that in the case of forming a laminated coating, the problem is further complicated. Because of this, patent document 2 recommends that oxygen and a coating precursor which have been premixed with each other should be brought into contact with the surface of the glass ribbon in the float bath. In this method, however, sealing is necessary for confining the oxygen gas, rendering the apparatus complicated. In addition, in the case where a coating station is contained in the annealing furnace and a metal oxide coating film is formed on the glass ribbon, the glass ribbon is rapidly deprived of heat, as compared with the case where the annealing furnace contains no coating station, due to heat exchange between the glass ribbon and the injector, resulting in a possibility that the glass ribbon might deform or that scratches and cracks might generate. In particular, the larger the number of coating stations, the higher the possibility of generating scratches and cracks. There are cases where the warped glass ribbon comes into contact with the coating station to thereby generate scratches and cracks in the glass.

Patent document 2 hence discloses a problem that in the case where one or more coating stations are contained in the annealing furnace in order to form a laminated coating, different temperature controls must be established. Despite this, the patent document discloses no specific method of suitable temperature control to be performed in the case where a plurality of coating stations have been disposed in the annealing furnace.

Patent document 3 discloses the feature of disposing a nozzle (injector) in the region between the outlet of a float bath and the inlet of an annealing furnace so as to cover the overall width of the glass. However, even though a conventional float manufacturing apparatus is desired to be utilized without changing, there is not a sufficient space for nozzle disposition between the float bath and the annealing furnace.

In addition, since no temperature control of the glass ribbon is being performed in the space between the float bath and the annealing furnace, deposition within the space between the float bath and the annealing furnace poses a problem that the glass ribbon is rapidly deprived of heat because of heat exchange between the nozzle and the glass ribbon.

The present invention has been achieved in view of the problems described above. The present invention provides a method for manufacturing a laminated film-coated glass substrate in which suitable temperature control of a glass ribbon is performed in an on-line CVD method and a laminated film is formed on the glass ribbon using a plurality of injectors disposed in the annealing furnace.

Means for Solving the Problems

The present invention provides the following aspects.

(1) A method for manufacturing a laminated film-coated glass substrate in which a glass manufacturing apparatus comprising a melting furnace capable of melting a raw material for a glass, a float bath capable of floating a molten glass on a molten metal to form a glass ribbon, and an annealing furnace capable of annealing the glass ribbon is used to form a laminated film on the glass ribbon by a CVD method by means of a plurality of injectors disposed above the glass ribbon in the annealing furnace and the glass ribbon is cut, wherein:

if a glass transition temperature is expressed by Tg, the laminated film is formed at Tg+50°C or lower, heater are disposed on the opposite side of the glass ribbon from each of the injectors in the annealing furnace, the heaters being paired with the injectors, respectively, and
in each of the injectors, if a quantity of heat exchanged between the injector and the glass ribbon is expressed by Q1 (kW), a quantity of heat exchanged between the heater paired with the injector and the glass ribbon is expressed by Q2 (kW), and an output of the glass is expressed by P (tons/day), then the following relational expression is satisfied:

$$|Q1| - P \times 0.116 \leq |Q2| \leq |Q1|.$$

(2) The method for manufacturing a laminated film-coated glass substrate according to (1), wherein the following relational expression is satisfied:

$$|Q1| - P \times 0.058 \leq |Q2| \leq |Q1|.$$

(3) The method for manufacturing a laminated film-coated glass substrate according to (1) or (2), wherein a heater is disposed at a position, which is between the injectors disposed adjacently along a conveying direction of the glass ribbon and is on the side of the injector with respect to the glass ribbon.
(4) The method for manufacturing a laminated film-coated glass substrate according to any one of (1) to (3), wherein a distance between a lower surface of the injector and the glass ribbon is 30 mm or less.

Effects of the Invention

According to the method for manufacturing a laminated film-coated glass substrate of the present invention, a method for manufacturing a laminated film-coated glass substrate has been rendered possible in which suitable temperature control of a glass ribbon is performed in an on-line CVD method and a laminated film is formed on the glass ribbon using a plurality of injectors disposed in the annealing furnace.

Brief Description of the Drawings

[FIG. 1] FIG. 1 is a diagrammatic view of a glass manufacturing apparatus.
[FIG. 2] FIG. 2 is a cross-sectional view of an injector.
[FIG. 3] FIG. 3 is a cross-sectional view of one embodiment of a transparent conductive substrate for solar cells which is produced by the method for manufacturing a laminated film-coated glass substrate of the present invention.
[FIG. 4] FIG. 4 is a graph which illustrates temperature control of a glass ribbon in an annealing furnace.

Modes for Carrying Out the Invention

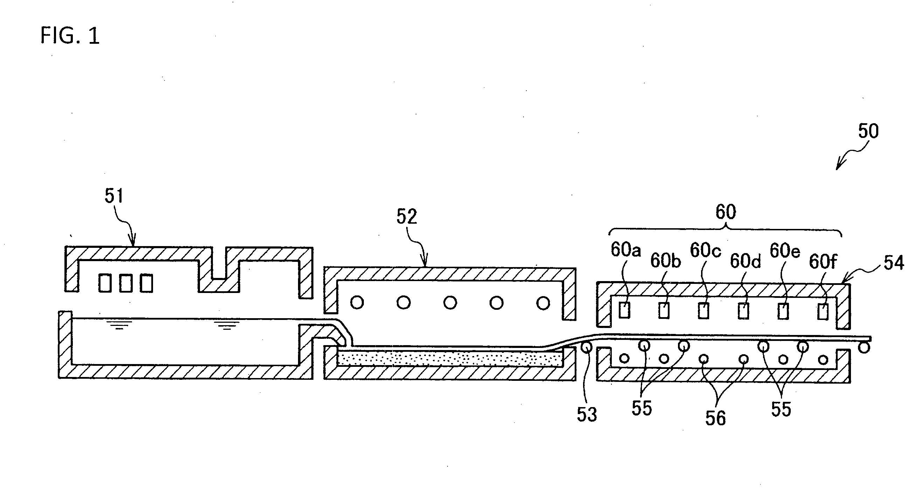

First, one embodiment of glass manufacturing apparatus for use in the method for manufacturing a laminated film-coated glass substrate of the present invention is explained by reference to FIG. 1. In the following explanations, there are cases where the formation of at least one of the layers of a laminated film is called deposition.

As shown in FIG. 1, a glass manufacturing apparatus 50 contains a melting furnace 51 capable of melting raw materials for glass, a float bath 52 capable of floating the molten glass obtained by the melting on molten tin to form a flat glass ribbon, and an annealing furnace 54 capable of annealing the glass ribbon by gradually lowering the temperature of the glass ribbon which has been pulled out from the float bath 52 with a lifting-out roll 53.

In the annealing furnace 54, heat is supplied to required positions in the annealing furnace by means of, for example, a combustion gas or an electric heater while controlling the output thereof, and the glass ribbon which is being conveyed with conveying rollers 55 is slowly cooled to a temperature range close to ordinary temperature. The annealing furnace 54 hence has the function of eliminating the residual stress present in the glass ribbon and inhibiting the glass ribbon from warping or cracking. A plurality of injectors 60 are disposed in the annealing furnace 54, and a laminated film is formed on the glass ribbon by a CVD method. The temperature of the glass ribbon at the time when the glass ribbon enters the annealing furnace 54 is frequently around 610°C (Tg+50°C) in the case of soda-lime silicate glasses.

The injectors 60 are composed of six injectors 60a to 60f and form a laminated film on the glass ribbon which is being conveyed. Electric heaters 56 that are paired respectively with the injectors 60a to 60f are disposed on the opposite side of the glass ribbon from the injectors 60. The number of the injectors 60 is not limited to that number, and is preferably in the range of 2 to 9. The number of the electric heaters also can be increased or reduced according to need. By means of the electric heaters, the temperature of the glass ribbon is prevented from becoming too low during the conveyance thereof from the inlet to the outlet of the annealing furnace.

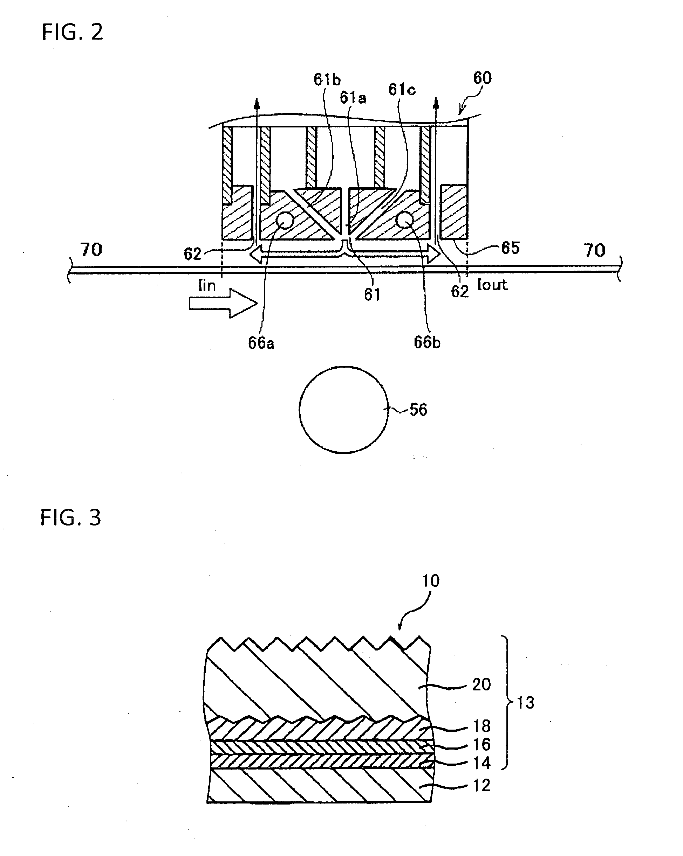

The injectors 60 (60a to 60f) are disposed on the opposite side of the glass ribbon 70 from the conveying rollers 55, i.e., disposed above the glass ribbon 70, as shown in FIG. 2. Each injector is provided with an inlet slot 61 in substantially the central part of the lower surface 65 thereof, the inlet slot 61 having a slit shape which is elongated in the direction perpendicular to the conveying direction of the glass ribbon, and with an exhaust slot 62 on each of both sides of the inlet slot 61, i.e., before and after the inlet slot 61, each exhaust slot 62 extending parallel with the inlet slot 61.

A first orifice 61 a which is located at the center and second and third orifices 6 1 b and 61c which are located respectively on both sides of the first orifice 61a, i.e., before and after the first orifice 61 a, are open in the inlet slot 61, the second and third orifices 61b and 61c each having been configured so as to form a channel that is inclined from a raw-material gas supply source toward the first orifice 61a. The width of the inlet slot 61 and exhaust slots 62 is set so as to be equal to or larger than the width of the glass ribbon 70. Signs 66a and 66b denote cooling ducts, through which a cooling medium such as a cooling gas or oil is circulated to keep the injector 60 at an optimal temperature, e.g., 100 to 220°C (measured on the lower surface of the injector). The lower surface of the injector 60 is a surface which comes into contact with raw-material gases, and in case where the temperature thereof is too high, the raw-material gases which have come into contact with the lower surface of the injector 60 undergo a reaction due to the heat and adhere thereto to deposit an unnecessary film. Because of this, as the upper limit thereof, it is preferably 250°C or lower. Meanwhile, too low temperatures thereof result in an increased amount of heat exchange with the glass ribbon to cause a rapid temperature drop of the glass ribbon. Consequently, as the lower limit thereof, it is preferably 100°C or higher.

The injectors 60 are disposed over the glass ribbon 70 at a distance of 3 to 30 mm therefrom. Consequently, the injectors 60 are disposed so that the lower surfaces 65 thereof face the glass ribbon 70 which is being conveyed in the annealing furnace 54, through a space of 3 to 30 mm. Smaller sizes of the space are preferred from the standpoints of film thickness, film quality, and deposition rate during deposition. However, in the case where the size of the space fluctuates due to the warpage or vibration of the glass ribbon, a greater influence is imposed on film thickness and film quality. In the case where the space is large, a decrease in raw-material efficiency during deposition is caused. When the film thickness, film quality, and deposition rate are taken into account, the space is preferably 4 to 12 mm, and more preferably 5 to 10 mm.

Through the first orifice 61 a, a gas containing a main raw material for a compound for forming an oxide film is introduced. Through the second and third orifices 6 1 b and 61 c, a reactant gas (gas serving as an oxygen source) for forming the oxide film is introduced. Through the exhaust slots 62, the excess gases remaining after the CVD reaction are discharged.

The composition of the glass ribbon can be suitably selected so long as forming by a float process is possible. Examples thereof include soda-lime silicate glasses, aluminosilicate glasses, lithium aluminosilicate glasses, borosilicate glasses, and alkali-free glasses. Of these, soda-lime silicate glasses are preferred from the standpoint that soda-lime silicate glasses are colorless and transparent, are inexpensive, and are easily available on the market in specified forms with respect to area, shape, plate thickness, etc.

The thickness of the glass ribbon can be suitably selected, and it is preferred that the glass thickness should be 0.1 to 6.0 mm. Thin glasses are less apt to have a temperature difference between the front and the back and are hence less prone to warp toward the injector side. However, since the glasses themselves are lightweight, the glass which has once warped toward the injector side does not recover from the warpage even with the aid of its own weight. Meanwhile, thick glasses are prone to have a temperature difference between the front and the back. However, force which reduces warpage is exerted thereon because of their own weight. Consequently, even when the glass thickness varies from 0.1 mm to 6.0 mm, the amount of warpage itself does not change considerably.

The kind, configuration, or the like of the laminated film to be deposited are not particularly limited, and can be suitably selected. The following explanation is given using examples in which a transparent conductive film for solar cells is formed. Examples of applications other than transparent conductive films for solar cells include antireflection films, heat-reflecting films and the like.

FIG. 3 is a cross-sectional view of one embodiment of a transparent conductive substrate for solar cells which is produced by the method for manufacturing a laminated film-coated glass substrate of the present invention. The transparent conductive substrate for solar cells is shown so that the light incidence-side surface thereof is located on the lower side in FIG. 3.

As shown in FIG. 3, the transparent conductive substrate 10 for solar cells includes, on/above a substrate 12, a titanium oxide layer 14, a silicon oxide layer 16, a first tin oxide layer 18, and a second tin oxide layer 20, as a laminated film 13, in this order from the substrate 12 side.

The material of the substrate 12 is not particularly limited, and examples thereof include soda-lime silicate glasses, aluminosilicate glasses, lithium aluminosilicate glasses, borosilicate glasses, and alkali-free glasses. Of these, soda-lime silicate glasses are preferred from the standpoint that soda-lime silicate glasses are colorless and transparent, are inexpensive, and are easily available on the market in specified forms with respect to area, shape, plate thickness, etc.

It is preferred that the thickness of the substrate 12 should be 0.2 to 6.0 mm. The substrate 12 having a thickness within this range has an excellent balance between mechanical strength and light-transmitting properties.

In FIG. 3, a titanium oxide layer 14 has been formed on the substrate 12. In the present invention, the embodiment which has a titanium oxide layer 14 between the substrate 12 and the silicon oxide layer 16 is one of suitable embodiments because the reflection which is caused at the interface between the substrate 12 and the tin oxide layers 18 and 20 by a difference in refractive index between the substrate 12 and the tin oxide layers 18 and 20 can be inhibited.

In order to form the laminated film 13 of this transparent conductive substrate 10 for solar cells by a CVD method in the annealing furnace 54 of the glass manufacturing apparatus 50 shown in FIG. 1, a titanium oxide layer 14 is formed on a glass ribbon, for example, with the first injector 60a, a silicon oxide layer 16 is formed with the second injector 60b, a first tin oxide layer 18 is formed with the third injector 60c, and a second tin oxide layer 20 is formed with the fourth to the sixth injectors 60d to 60f.

In this case, at the inlet slot 61 of the first injector 60a, vaporized tetraisopropoxytitanium is blown from the first orifice 61a and nitrogen gas is blown from the second and third orifices 6 1 b and 61 c. As a result, the tetraisopropoxytitanium undergoes a pyrolysis reaction on the glass ribbon to form a titanium oxide layer 14 on the surface of the glass ribbon which is being conveyed.

At the inlet slot 61 of the second injector 60b, silane gas is blown from the first orifice 61 a and oxygen gas is blown from the second and third orifices 6 1 b and 61 c. As a result, the silane gas and the oxygen gas are mixed and reacted with each other on the titanium oxide 14 layer of the glass ribbon to form a silicon oxide layer 16 on the surface of the titanium oxide layer 14 of the glass ribbon which is being conveyed.

At the inlet slot 61 of the third injector 60c, tin tetrachloride is blown from the first orifice 61a and water vapor is blown from the second and third orifices 6 1 b and 61 c. As a result, the tin tetrachloride and the water are mixed and reacted with each other on the silicon oxide layer 16 of the glass ribbon to form a first tin oxide layer 18, which has not been doped with fluorine, on the surface of the silicon oxide layer 16 of the glass ribbon that is being conveyed.

At the inlet slots 61 of the fourth to sixth injectors 60d to 60f, tin tetrachloride is blown from the first orifices 61a and water vapor and vaporized hydrogen fluoride are blown from the second and third orifices 61b and 61c. As a result, the tin tetrachloride, the water, and the hydrogen fluoride are mixed and reacted with each other on the first tin oxide layer 18 of the glass ribbon to form a second tin oxide layer 20, which has been doped with fluorine, on the surface of the first tin oxide layer 18 of the glass ribbon that is being conveyed.

The glass ribbon above which the second tin oxide layer 20 has been formed is discharged, while being conveyed, from the annealing furnace 54, cooled to around room temperature, cut into a desired size, and carried out as transparent conductive substrates 10 for solar cells.

It is preferred in the deposition in the annealing furnace that oxide materials such as titanium oxide, silicon oxide, and tin oxide should be deposited as described above. The atmosphere in the annealing furnace is air, because it is easy to supply oxygen molecules, e.g., oxygen gas, when oxides are formed.

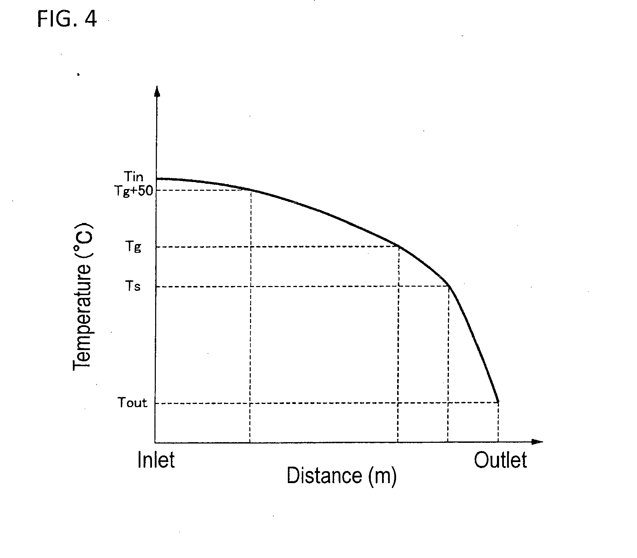

Here, the temperature control of the glass ribbon during deposition is explained while referring also to FIG. 4.

If the surface temperature of the glass ribbon at the time when the glass ribbon passes through the inlet of the annealing furnace 54 is expressed by Tin, the surface temperature of the glass ribbon at the time when the glass ribbon passes through the outlet of the annealing furnace 54 is expressed by Tout, the glass transition temperature is expressed by Tg, and the glass strain temperature is expressed by Ts, then the surface temperature of the glass ribbon on which deposition is to be performed is Tg+50°C or lower but not lower than Ts. In the case where the glass ribbon has a surface temperature higher than Tg+50°C, this glass ribbon is prone to suffer "stamping flaws" or surface defects. In the case where the surface temperature thereof is lower than Ts, the raw-material gases undergo insufficient reaction due to heat.

The laminated film 13 described above which is composed of the titanium oxide layer 14, silicon oxide layer 16, first tin oxide layer 18, and second tin oxide layer 20 is formed at temperatures not higher than Tg+50°C. The laminated film 13 is formed preferably in the range of Tg+50°C to Ts, more preferably in the temperature range of Tg+50°C to Tg (or in the temperature range of Tin to Tg in the case where Tin is lower than Tg+50°C).

In the case where the temperature of the glass ribbon declines to below Tg, there is a possibility that the glass ribbon might suffer considerable fluttering due to the contraction which accompanies a viscosity change of the glass. It is therefore preferred that all layers should be formed in the temperature range of Tg+50°C to Tg. Thus, the fluttering of the glass ribbon can be inhibited regardless of the viscosity of the glass. In the case where deposition is conducted also in the temperature range of Tg to Ts, the number of layers to be formed in the temperature range of Tg to Ts is preferably 3 or less, more preferably 2 or less.

At temperatures not lower than Tg+50°C, the glass ribbon is soft and deposition on this glass ribbon is less apt to result in warpage or cracking of the glass ribbon.

The injectors 60 are kept at a temperature lower than that of the glass ribbon. Because of this, heat exchange with the injectors 60 occurs during the deposition to lower the temperature of the glass ribbon.

A specific explanation is given while referring to Fig. 2. In the lower surface 65 of the injector which faces the glass ribbon, the end thereof along the conveying direction of the glass ribbon 70 which is on the float bath 52 side is the inlet Iin of the injector, and the end thereof which is on the side opposite from the float bath 52 is the outlet Iout of the injector. The glass ribbon which has entered the inlet Iin of the injector decreases in temperature because of the heat dissipation and the heat exchange with the injector and is cooled before being carried out through the outlet Iout of the injector. The temperature decrease during conveyance from the Iin to the Iout is regulated to preferably 0°C or more and 10°C or less, more preferably 5°C or more and 10°C or less. In the case where the temperature by which the glass ribbon is cooled during conveyance from the inlet Iin to the outlet Iout of each injector is more than 10°C, this glass ribbon has an increased difference in temperature between the upper surface thereof and the lower surface thereof. Because of this, the glass ribbon is prone to deform considerably and a contact between the injector and the glass ribbon is prone to occur, resulting in scratches and cracks of the glass ribbon. Meanwhile, it is necessary to lower the temperature of the glass ribbon in the annealing furnace 54 to anneal the glass ribbon, and the glass ribbon is cooled in the annealing furnace 54 to a temperature not higher than the Ts. In view of this, it is preferred that the temperature by which the glass ribbon is cooled during conveyance from the inlet Iin of the injector to the outlet Iout of the injector in each of the injectors 60a to 60f should be 5°C or more. So long as the temperature is 5°C or more, the glass ribbon is cooled at a higher rate and the size of the annealing furnace can be shortened.

In the annealing furnace 54, the whole laminated film is deposited at Tg+50°C or lower. Namely, the deposition is conducted on the glass which is in a hard state. Because of this, in the case where a rapid temperature change is occurred, there is a possibility that the glass ribbon might deform considerably, resulting in the increased possibility of a contact between the injector and the glass ribbon. Consequently, in order to inhibit the glass ribbon from suffering scratches and cracks due to the contact between the injector and the glass ribbon, it is necessary that the temperature by which the glass ribbon is cooled during conveyance from the inlet Iin to the outlet Iout of each injector should be regulated to 10°C or less.

Those temperatures of the glass ribbon are temperatures of the upper surface (deposition side) of the glass ribbon. It is preferred that during the film deposition, the difference in temperature between the upper surface of the glass ribbon and the lower surface thereof in the same position should be 10°C or less. By regulating the difference in temperature between the upper surface of the glass ribbon and the lower surface thereof in the same position to 10°C or less, the glass ribbon is further inhibited from warping below the injectors and contacts between the injectors and the glass ribbon are more reliably inhibited.

Here, if the output of the glass ribbon is expressed by P (ton/day) and the specific heat of the glass is expressed by Cg (J/(kg·°C)), then the quantity of heat Qg (W) which is removed from the glass until the temperature of the glass ribbon declines by 10°C is determined using the following equation. The unit of the quantity of heat Q in the present invention is W (watt) or kW (kilowatt), and can be regarded as an electric power-converted value obtained by converting the quantity of heat into electric power.

$$Qg\ (W) = P \times 1000/24/3600 \times Cg \times 10$$
$$= 0.116 \times P \times Cg$$

Here, the specific heat of the glass is taken as Cg = 1,000 J/(kg·°C), and the following equation is satisfied.

$$Qg\ (kW) = 0.116 \times P \qquad\qquad (1)$$

Namely, in the case where the glass ribbon is deprived of heat in a quantity not less than Qg = 0.116×P (kW) during the period from the entrance thereof into the inlet Iin of the injector to the carrying-out thereof from the outlet Iout of the injector, this glass ribbon cracks.

More preferably, the temperature by which the glass ribbon which enters the inlet Iin of the injector is cooled during the period from the entrance to the carrying-out thereof from the outlet Iout of the injector is 5°C or less. In the case where the temperature is 5°C or less, the quantity of heat is Q'g = 0.058×P.

Since the decrease in temperature of the glass ribbon is governed mainly by the removal of heat by the injectors, the heat balance of the glass ribbon during conveyance from the inlet Iin to the outlet Iout of each injector has been studied. The glass ribbon receives heat from the heater and is deprived of heat by the injector. Consequently, if the quantity of heat exchanged between the glass ribbon being conveyed from the inlet Iin to the outlet Iout of the injector and the lower surface 65 of the injector (the quantity of heat removed from the glass ribbon and transferred to the injector) is expressed by Q1 (kW) and the quantity of heat exchanged between the electric heater 56 and the glass ribbon (the quantity of heat transferred from the heater to the glass ribbon) is expressed by Q2 (kW), then the quantity of heat removed from the glass during conveyance from the inlet Iin to the outlet Iout of each injector is |Q1|-|Q2| (kW).

Therefore, in order for the glass ribbon not to crack, the quantity of heat removed from the glass during conveyance from the inlet Iin to the outlet Iout of each injector (|Q1|-|Q2|) may be regulated to Qg = 0.116×P or less. Hence, the following relational expression (2) is satisfied.

$$0 \le |Q1| - |Q2| \le 0.116 \times P \qquad\qquad (2)$$

The reason for |Q1|-|Q2|≥0 is that, in the case where the quantity of heat removed from the glass ribbon is less than the quantity of heat transferred thereto although the glass ribbon is in the annealing furnace 54, the temperature of the glass ribbon rises, and hence, a prolonged conveyance distance becomes necessary for cooling to around room temperature, resulting in an increase in the size of the apparatus.

The above expression (2) is rearranged to express the quantity Q2 (kW) of heat exchanged between the electric heater 56 and the glass ribbon (quantity of heat transferred from the heater to the glass ribbon) by the following expression (3).

$$|Q1| - P \times 0.116 \le |Q2| \le |Q1| \qquad\qquad (3)$$

The quantity of exchanged heat is more preferably as follows.

$$|Q1|-Q'g \le |Q2| \le |Q1|,$$

i.e.,

$$|Q1|-P\times0.058 \le |Q2| \le |Q1| \qquad\qquad (4)$$

The quantity of heat Q1 exchanged between the glass ribbon and the lower surface 65 of each injector during conveyance from the inlet Iin to the outlet Iout of the injector is equal to the radiant heat Q1 transferred between the glass ribbon and the lower surface of the injector, and is calculated using the following radiation equation (5).

$$Q1 = S1\times\varepsilon1\times F1\times\sigma(T_{gla}^{4}-T_{inj}^{4}) \qquad\qquad (5)$$

S1 is the surface area ($m^2$) of the lower surface of the injector; $\varepsilon1$ is radiation factor; F1 is surface-to-surface view factor; $\sigma$ is Boltzmann's constant ($5.67\times10^{-8}$ ($W/m^2\cdot K^4$)); $T_{gla}$ is the temperature (K) of the glass ribbon represented by $K = (T_{in}+T_{out})/2$ using both a measured value $T_{in}$ obtained by measuring the temperature of the glass ribbon at the inlet of the injector by bringing thermocouple Type K into contact therewith and a measured value $T_{out}$ obtained by measuring the temperature of the glass ribbon at the outlet of the injector by bringing thermocouple Type K into contact therewith; and $T_{inj}$ is the temperature (K) of the lower surface of the injector.

The quantity Q2 of heat exchanged between the electric heater 56 and the glass ribbon (quantity of heat transferred from the heater to the glass ribbon) is equal to the radiant heat Q2 (kW) transferred between the glass ribbon and the surface of the heater paired with each injector, and is calculated using the following radiation equation (6).

$$Q2 = S2\times\varepsilon2\times F2\times\sigma(T_{gla}^{4}-T_{inj}^{4}) \qquad\qquad (6)$$

S2 is the surface area ($m^2$) of the heater; $\varepsilon2$ is radiation factor; F2 is surface-to-surface view factor; $\sigma$ is Boltzmann's constant ($5.67\times10^{8}$ ($W/m^2\cdot K^4$)); $T_{gla}$ is the temperature (K) of the glass ribbon represented by $K = (T_{in}+T_{out})/2$ using both a measured value $T_{in}$ obtained by measuring the temperature of the glass ribbon at the inlet of the injector by bringing thermocouple Type K into contact therewith and a measured value $T_{out}$ obtained by measuring the temperature of the glass ribbon at the outlet of the injector by bringing thermocouple Type K into contact therewith; and $T_{inj}$ is the temperature (K) of the lower surface of the injector.

Although Cg = 1,000 J/(kg·°C) was used here, Cg may be 1,000 to 1,200 J/(kg·°C). Although 1 was used as the radiation factor $\varepsilon$, the radiation factor $\varepsilon$ may be 0.8 to 1.0. It is preferred that the output P of the glass ribbon should be 100 to 700 ton/day.

Furthermore, if the "temperature drop per unit length of the glass ribbon in the temperature range where the whole laminated film is formed" is called K1 (hereinafter also referred to simply as temperature drop K1), K1 is set so that 0°C/m < K1 < 10°C/m, preferably 1°C/m ≤ K1 ≤ 5°C/m, more preferably 2°C/m ≤ K1 ≤ 3°C/m. Consequently, in the case where all layers are to be deposited in the temperature range of Tg+50°C to Tg, the temperature drop K in the temperature range of Tg+50°C to Tg is set so that 0°C/m < K1 < 10°C/m; and in the case where the deposition is to be conducted also in the temperature range of Tg to Ts, the temperature drop K in the temperature range of Tg+50°C to Ts is set so that 0°C/m < K1 < 10°C/m.

The temperature drop K1 is a value obtained by dividing "the temperature difference between the temperature of the glass ribbon at the inlet of the first injector in laminated film formation and the temperature of the glass ribbon at the outlet of the last injector" in the temperature range where the laminated film is formed by "the difference in distance between the position of the inlet of the first injector for laminated film formation and the position of the outlet of the last injector". In the case where the temperature drop K1 is 10°C/m or larger, there is a possibility that scratches and cracks due to a deformation of the glass ribbon might occur. In the case where the temperature drop K1 is 0°C/m, this means that the glass ribbon is not annealed in the annealing furnace 54 during the deposition and is annealed after the deposition, resulting in the necessity of prolonging the annealing furnace 54.

After having been cooled in the manner described above, the glass ribbon is cut into a desired size to obtain a laminated film-coated substrate.

In the case where the temperature drop K1 of the glass ribbon in the temperature range where the whole laminated film 13 is formed does not satisfy 0°C/m < K1 < 10°C/m even though the temperature by which the glass ribbon is cooled during conveyance from the inlet Iin to the outlet Iout of each injector is 10°C or less, it is possible to make the glass ribbon as a whole satisfy the temperature drop K1 by disposing electric heaters 56 between the injectors 60 disposed adjacently along the conveying direction of the glass ribbon and suitably heating the glass ribbon.

Examples

Examples of the present invention are explained below.
In the Examples explained below, temperature measurements were made with contact type thermocouple Type K (sensor; 231K-TC1-ASP, manufactured by Anritsu Meter Co., Ltd.).

<Example 1>

In this Example, in the production of a soda-lime glass, six injectors 60a to 60f and electric heaters 56 were disposed in an annealing furnace, so that the electric heaters 56 were located on the opposite side of the glass ribbon from the injectors 60a to 60f and were paired respectively with the injectors 60a to 60f, as shown in FIG. 2. A titanium oxide layer 14 was formed on the glass ribbon with the first injector 60a, a silicon oxide layer 16 was formed thereon with the second injector 60b, a first tin oxide layer 18 was formed thereon with the third injector 60c, and a second tin oxide layer 20 was formed thereon with the fourth to sixth injectors 60d to 60f, as shown in FIG. 3. Thereafter, the glass ribbon was cut to thereby form a substrate coated with a transparent conductive film 10 for solar cells. The gases introduced from each of the injectors 60a to 60f are as described above. The space between the lower surfaces of the injectors and the glass ribbon was regulated to 7 mm $\pm$ 1 mm. The six injectors were disposed at regular intervals of 2 m. The output P of the glass ribbon was 500 ton/day, and the area S of the lower surface of the injector was 1.76 m$^2$.
Use was made of a soda-lime glass having a glass transition temperature Tg of 560°C, a glass strain temperature Ts of 510°C, and a plate thickness of 3.2 to 3.9 mm. The temperature of the glass ribbon was determined by measuring the temperature of the upper surface of the glass ribbon with the contact type thermocouple Type K.
The temperature of the glass ribbon was measured before and after the injector. The distance between the measuring points was 2 m. The temperature of the glass ribbon surface which underlay the center of the injector was determined by a calculation. Since the main factor which contributes to the decrease of the temperature of the glass ribbon is cooling due to radiation to the injectors, the average of the temperatures measured before and after the injector was taken as the temperature of the glass ribbon surface underlying the center of the injector. The temperature measurement positions during the deposition of a transparent conductive film using the six injectors and the temperatures of the glass ribbon at the centers of the injectors are shown in Table 1.

[Table 1]

| Position | | Glass ribbon temperature | | Temperature change with one injector |
|---|---|---|---|---|
| Distance | | Measured temperature | Calculated value | |
| (m) | Position name | (°C) | (°C) | (°C) |
| 0 | Temperature measurement position 1 | 600 | | |
| | Position of injector 1 | | 595 | 10°C |
| 2 | Temperature measurement position 2 | 590 | | |
| | Position of injector 2 | | 586 | 8°C |
| 4 | Temperature measurement position 3 | 582 | | |
| | Position of injector 3 | | 578 | 8°C |
| 6 | Temperature measurement position 4 | 574 | | |
| | Position of injector 4 | | 569.5 | 9°C |
| 8 | Temperature measurement position 5 | 565 | | |

(continued)

| Position | | Glass ribbon temperature | | Temperature change with one injector |
| --- | --- | --- | --- | --- |
| Distance | | Measured temperature | Calculated value | |
| (m) | Position name | (°C) | (°C) | (°C) |
| | Position of injector 5 | | 561 | 8°C |
| 10 | Temperature measurement position 6 | 557 | | |
| | Position of injector 6 | | 553.5 | 7°C |
| 12 | Temperature measurement position 7 | 550 | | |

As apparent from Table 1, the temperature by which the glass ribbon was cooled during conveyance from the inlet to the outlet of each injector was 10°C or less.

The temperature difference between the temperature at the inlet of the first injector and the temperature at the outlet of the last injector was determined from Table 1, and this temperature difference was divided by the difference in distance between the position of the inlet of the first injector and the position of the outlet of the last injector, i.e., 10.5 m. The thus-determined temperature drop K1 per unit length in the temperature range where all layers were formed is shown in Table 2.

[Table 2]

| Temperature drop K1 per unit length in the temperature range where all layers were formed | 4.8°C/m |
| --- | --- |

As shown in Table 2, the temperature drop K1 per unit length in the temperature range where all layers were formed was 4.8°C/m.

With respect to each injector, the quantity Q1 of exchanged heat transferred from the glass ribbon to the injector was calculated using the equation (5) given above, i.e., $Q1=S1\times\varepsilon1\times F1\times\sigma(T_{gla}^4-T_{inj}^4)$. The value of Q1 in the case where S1 was 1.76 $m^2$, the radiation factor $\varepsilon$ was 1, the view factor F was 1, and the temperature of the lower surface of the injector was 150°C is shown in Table 3 together with the value of $|Q1|-P\times0.116$.

The position of the heater paired with the injector was on the opposite side of the glass ribbon from the injector, and the glass ribbon below the injector was heated from an oblique direction. Since the quantity Q2 (kW) of heat exchanged with the glass ribbon was unable to be actually measured, a value of Q2 was determined on the basis of the maximum value of electric energy inputted to the heater and is expressed as a range of positive values because the glass ribbon below the injector was heated by the heater. The value thereof is shown in Table 3.

[Table 3]

| | $|Q1|-P\times0.116$ (kW) | Q2 (kW) | Q1 (kW) |
| --- | --- | --- | --- |
| INJ-1 | -4.5 | 0<Q2<26.7 | 53.5 |
| INJ-2 | -6.8 | 0<Q2<28.2 | 51.2 |
| INJ-3 | -8.8 | 0<Q2<29.7 | 49.2 |
| INJ-4 | -10.9 | 0<Q2<29.7 | 47.1 |
| INJ-5 | -12.9 | 0<Q2<30.2 | 45.1 |
| INJ-6 | -14.6 | 0<Q2<30.7 | 43.4 |

Although Q2 was unable to be determined accurately, Q2 was between $(|Q1|-P\times0.116)$ and Q1. In the case where $|Q1|-P\times0.116$ is negative, this means that the glass ribbon does not crack even when exchange of heat Q2 with the heater does not occur (Q2 is zero); that case does not mean that Q2 actually has a negative value.

After having been cooled, the glass ribbon was cut into a desired size to obtain a transparent conductive film-coated substrate for solar cells. In the thus-produced transparent conductive substrate for solar cells, the film deposition with six injectors in the annealing furnace was able to be carried out without causing the problem that a contact between the injector and the glass ribbon caused scratches and cracks to the glass ribbon.

<Example 2>

Deposition was conducted using six injectors while cooling a soda-lime glass in an annealing furnace in the same manner as in Example 1, except that the output and plate thickness of the glass ribbon, and conditions for heating with the heaters were changed. The soda-lime glass used here had a Tg of 560°C and a Ts of 510°C. The output P of the glass ribbon was 640 tons/day, the plate thickness was 2.2 mm, and the area S of the lower surface of the injector was 1.76 m$^2$.

As in Example 2, the temperature measurement positions during the deposition of a transparent conductive film using the six injectors and the temperatures of the glass ribbon at the centers of the injectors are shown in Table 4.

[Table 4]

| Position | | Glass ribbon temperature | | Temperature change with one injector |
|---|---|---|---|---|
| Distance | | Measured temperature | Calculated value | |
| (m) | Position name | (°C) | (°C) | (°C) |
| 0 | Temperature measurement position 1 | 577 | | |
| | Position of injector 1 | | 573.5 | 7°C |
| 2 | Temperature measurement position 2 | 570 | | |
| | Position of injector 2 | | 567 | 6°C |
| 4 | Temperature measurement position 3 | 564 | | |
| | Position of injector 3 | | 561 | 6°C |
| 6 | Temperature measurement position 4 | 558 | | |
| | Position of injector 4 | | 555 | 6°C |
| 8 | Temperature measurement position 5 | 552 | | |
| | Position of injector 5 | | 549 | 6°C |
| 10 | Temperature measurement position 6 | 546 | | |
| | Position of injector 6 | | 543.5 | 5°C |
| 12 | Temperature measurement position 7 | 541 | | |

As apparent from Table 4, the temperature by which the glass ribbon was cooled during conveyance from the inlet to the outlet of each injector was 10°C or less.

The temperature difference between the temperature at the inlet of the first injector and the temperature at the outlet of the last injector was determined from Table 4, and this temperature difference was divided by the difference in distance between the position of the inlet of the first injector and the position of the outlet of the last injector, i.e., 10.5 m. The thus-determined temperature drop K1 per unit length in the temperature range where all layers were formed is shown in Table 5.

[Table 5]

| Temperature drop K1 per unit length in the temperature range where all layers were formed | 3.4°C/m |
|---|---|

As shown in Table 5, the temperature drop K1 per unit length in the temperature range where all layers were formed was 3.4°C/m.

With respect to each injector, the quantity Q1 of exchanged heat transferred from the glass ribbon to the injector was calculated using the equation (5) given above, i.e., $Q1 = S1 \times \varepsilon 1 \times F1 \times \sigma(T_{gla}^4 - T_{inj}^4)$. The value of Q1 in the case where S1 was 1.76 $m^2$, the radiation factor $\varepsilon$ was 1, the view factor F was 1, and the temperature of the lower surface of the injector was 150°C is shown in Table 6 together with the value of $|Q1| - P \times 0.116$.

The position of each heater paired with an injector was on the opposite side of the glass ribbon from the injector, and the glass ribbon below the injector was heated from an oblique direction. Since the quantity Q2 (kW) of heat exchanged with the glass ribbon was unable to be actually measured, a value of Q2 was determined on the basis of the maximum value of electric energy inputted to the heater and is expressed as a range of positive values because the glass ribbon below the injector was heated by the heater. The value thereof is shown in Table 6.

[Table 6]

|  | $|Q1| - P \times 0.116$ (kW) | Q2 (kW) | Q1 (kW) |
|---|---|---|---|
| INJ-1 | -26.1 | 0<Q2<29.4 | 48.1 |
| INJ-2 | -27.7 | 0<Q2<27.8 | 46.5 |
| INJ-3 | -29.1 | 0<Q2<26.2 | 45.1 |
| INJ-4 | -30.5 | 0<Q2<26.2 | 43.7 |
| INJ-5 | -31.8 | 0<Q2<27.3 | 42.4 |
| INJ-6 | -33.0 | 0<Q2<28.5 | 41.2 |

Although Q2 was unable to be determined accurately, Q2 was between ($|Q1| - P \times 0.116$) and Q1. In the case where $|Q1| - P \times 0.116$ is negative, this means that the glass ribbon does not crack even when exchange of heat, Q2, with the heater does not occur (Q2 is zero); that case does not mean that Q2 actually has a negative value.

After having been cooled, the glass ribbon was cut into a desired size to obtain a transparent conductive film-coated substrate for solar cells. In also the thus-produced transparent conductive substrate for solar cells, the deposition with six injectors in the annealing furnace was able to be carried out without causing the problem that a contact between the injector and the glass ribbon caused scratches and cracks to the glass ribbon.

<Reference Examples>

Furthermore, when a transparent conductive film for solar cells was deposited in the production process of the present invention, the temperature of the lower surface of the glass ribbon was measured at each of the positions where the temperatures of the upper surface of the glass ribbon were 590°C, 560°C, and 550°C.

Temperature of the lower surface of the glass ribbon at the position where the temperature of the upper surface was 590°C: 580°C

Temperature of the lower surface of the glass ribbon at the position where the temperature of the upper surface was 560°C: 560°C

Temperature of the lower surface of the glass ribbon at the position where the temperature of the upper surface was 550°C: 550°C

The temperature differences in the thickness direction of the glass ribbon were 10°C or less.

It can be seen from the results that in the production process of the present invention, the glass ribbon has a narrow temperature distribution in the thickness direction, and it is presumed that the glass ribbon warps little.

As explained above, according to the method for manufacturing the glass substrate shown as the present embodiments, a contact between the injector and the glass ribbon can be avoided and the glass ribbon can be inhibited from suffering scratches or cracks, when a laminated film is formed on the glass ribbon in the annealing furnace by an on-line CVD method, by forming the laminated film at Tg+50°C or lower and by heating the glass ribbon with electric heaters 56 paired with the injectors 60a to 60f, so that in each of the injectors 60a to 60f, if the quantity of heat exchanged between each of the injectors 60a to 60f and the glass ribbon is expressed by Q1 (kW), the quantity of heat exchanged between the heater paired with each of the injectors 60a to 60f and the glass ribbon is expressed by Q2 (kW), and the output of the glass is expressed by P (ton/day), then the relational expression $|Q1| - P \times 0.116 \leq |Q2| \leq |Q1|$ is satisfied to thereby prevent the temperature of the glass ribbon from being excessively lowered by the injectors 60a to 60f. It is more preferred to heat the glass ribbon so that the relational expression $|Q1| - P \times 0.058 \leq |Q2| \leq |Q1|$ is satisfied.

In the case where $|Q1| - P \times 0.116$ and $|Q1| - P \times 0.058$ have negative values, this means that the glass ribbon does not crack even when the quantity Q2 of heat from the heaters is zero.

In the case where the heater which is paired with the injector and located on the opposite side of the glass ribbon from the injector is right below the injector, this heater heats the glass ribbon located right above the heater, i.e., the glass ribbon located right below the injector. In the case where the heater which is paired with the injector and located on the opposite side of the glass ribbon from the injector is located in a position shifted leftward or rightward from right below the injector, the glass ribbon right below the injector is heated by oblique radiation from the heater. In this case, if there are a plurality of heaters which heat the glass ribbon located right below the injector, this means that there are a plurality of heaters which are paired with one injector. The term "heater paired with an injector" means a heater which heats at least the portion of the glass ribbon which is located right below the lower surface of the injector.

The present invention is not limited to the above-described embodiments, and will be carried out with various modifications without departing from the spirit and scope thereof.

For example, although the electric heaters are exemplified as a heater, any heating means can be used without limiting thereto.

This application is based on Japanese Patent Application No. 2011-154315 filed on July 12, 2011, the entire subject matters of which are incorporated herein by reference.

Description of Reference Numerals

| | |
|---|---|
| 10 | Transparent conductive substrate for solar cell |
| 13 | Laminated film |
| 50 | Glass manufacturing apparatus |
| 51 | Melting furnace |
| 52 | Float bath |
| 54 | Annealing furnace |
| 56 | Electric heater (Heater) |
| 60 | Injector |
| 70 | Glass ribbon |

**Claims**

1. A method for manufacturing a laminated film-coated glass substrate in which a glass manufacturing apparatus comprising a melting furnace capable of melting a raw material for a glass, a float bath capable of floating a molten glass on a molten metal to form a glass ribbon, and an annealing furnace capable of annealing the glass ribbon is used to form a laminated film on the glass ribbon by a CVD method by means of a plurality of injectors disposed above the glass ribbon in the annealing furnace and the glass ribbon is cut, wherein:

   if a glass transition temperature is expressed by Tg, the laminated film is formed at Tg+50°C or lower,
   heater are disposed on the opposite side of the glass ribbon from each of the injectors in the annealing furnace, the heaters being paired with the injectors, respectively, and
   in each of the injectors, if a quantity of heat exchanged between the injector and the glass ribbon is expressed by Q1 (kW), a quantity of heat exchanged between the heater paired with the injector and the glass ribbon is expressed by Q2 (kW), and an output of the glass is expressed by P (tons/day), then the following relational expression is satisfied:

$$|Q1| - P \times 0.116 \leq |Q2| \leq |Q1|.$$

2. The method for manufacturing a laminated film-coated glass substrate according to claim 1, wherein the following relational expression is satisfied:

$$|Q1| - P \times 0.058 \leq |Q2| \leq |Q1|.$$

3. The method for manufacturing a laminated film-coated glass substrate according to claim 1 or 2, wherein a heater is disposed at a position, which is between the injectors disposed adjacently along a conveying direction of the glass ribbon and is on the side of the injector with respect to the glass ribbon.

4. The method for manufacturing a laminated film-coated glass substrate according to any one of claims 1 to 3, wherein a distance between a lower surface of the injector and the glass ribbon is 30 mm or less.

EP 2 733 125 A1

FIG. 1

15

FIG. 2

FIG. 3

FIG. 4

## INTERNATIONAL SEARCH REPORT

| | International application No. |
|---|---|
| | PCT/JP2012/067867 |

### A. CLASSIFICATION OF SUBJECT MATTER

*C03C17/245*(2006.01)i, *C03B25/08*(2006.01)i, *C03C17/34*(2006.01)i, *C23C16/40* (2006.01)i, *H01L31/04*(2006.01)i

According to International Patent Classification (IPC) or to both national classification and IPC

### B. FIELDS SEARCHED

Minimum documentation searched (classification system followed by classification symbols)
C03C15/00-23/00, C03B25/08, C23C16/40, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2010/067850 A1 (Asahi Glass Co., Ltd.), 17 June 2010 (17.06.2010), claims 11 to 18; paragraphs [0043] to [0045]; examples; fig. 3 & EP 2377832 A1 & TW 201033148 A | 1-4 |
| A | JP 2001-192234 A (Nippon Sheet Glass Co., Ltd.), 17 July 2001 (17.07.2001), claims; examples; paragraph [0030]; fig. 1 (Family: none) | 1-4 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 09 October, 2012 (09.10.12) | 23 October, 2012 (23.10.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2012/067867

C (Continuation). DOCUMENTS CONSIDERED TO BE RELEVANT

| Category* | Citation of document, with indication, where appropriate, of the relevant passages | Relevant to claim No. |
|---|---|---|
| A | JP 61-040844 A (PPG Industries, Inc.),<br>27 February 1986 (27.02.1986),<br>claims; page 4, upper right column, line 11 to<br>page 8, upper left column, line 14; example 1;<br>fig. 3<br>& US 4584206 A & US 4900110 A<br>& EP 170216 A1 & DE 3572961 D<br>& ES 545652 A & BR 8503600 A<br>& CA 1275876 A & ZA 8505133 A<br>& KR 10-1992-0004850 B & CN 85106614 A | 1-4 |
| A | JP 52-124427 A (BFG Glassgroup),<br>19 October 1977 (19.10.1977),<br>claims; examples; fig. 1<br>& US 4125391 A & GB 1523991 A<br>& DE 2716181 A & FR 2348167 A<br>& BE 853200 A & NL 7703993 A<br>& AU 2411877 A & SE 7703973 A<br>& ES 457597 A & ES 457598 A<br>& FI 771067 A & BR 7702329 A<br>& CA 1092904 A & DK 151777 A<br>& IL 51830 A & ZA 7702109 A<br>& IT 1082731 B & MX 4561 E | 1-4 |
| A | JP 03-033036 A (Glaverbel),<br>13 February 1991 (13.02.1991),<br>claims; page 4, upper left column, line 9 to<br>upper right column, line 6; page 5, upper left<br>column, line 14 to upper right column, line 13;<br>drawings<br>& US 5089039 A & US 5221352 A<br>& GB 8914047 A & GB 2234264 A<br>& GB 8914047 A0 & DE 4018996 A<br>& FR 2648453 A & BE 1004216 A<br>& CH 681804 A & NL 9001349 A<br>& NO 902701 A & SE 9002132 A<br>& IT 1241245 A & LU 87745 A<br>& CA 2019191 A & ES 2020479 A | 1-4 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1201046 A
- JP 3033036 A
- JP 4035558 B
- JP 2011154315 A